Europäisches Patentamt

European Patent Office

Office européen des brevets

(19)

(11) Veröffentlichungsnummer: **0 108 368**

**A1**

(12) # EUROPÄISCHE PATENTANMELDUNG

(21) Anmeldenummer: **83110869.1**

(22) Anmeldetag: **31.10.83**

(51) Int. Cl.³: **F 21 Q 3/00**
**H 01 L 33/00**

(30) Priorität: **03.11.82 DE 8230756 U**

(43) Veröffentlichungstag der Anmeldung:
**16.05.84 Patentblatt 84/20**

(84) Benannte Vertragsstaaten:
**DE FR GB IT NL**

(71) Anmelder: **Honeywell-Elac-Nautik GmbH**
**Westring 425-429**
**D-2300 Kiel(DE)**

(72) Erfinder: **Sakowski, Reinhard**
**Willestrasse 4 - 6**
**D-2300 Kiel 1(DE)**

(74) Vertreter: **Rentzsch, Heinz et al,**
**Honeywell Europe S.A. Holding KG Patent- und**
**Lizenzabteilung Kaiserleistrasse 55**
**D-6050 Offenbach am Main(DE)**

(54) Optische Warn- oder Anzeigeeinrichtung mit Leuchtdioden.

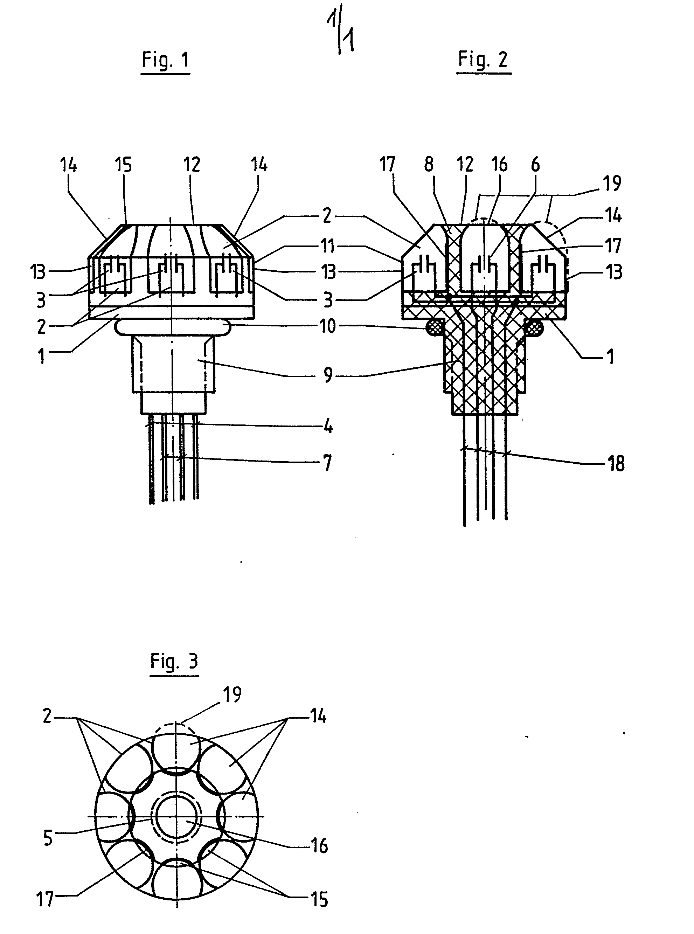

(57) Eine kompakte optische Warn- oder Anzeigeeinrichtung mit Leuchtdioden besteht aus einer kreis- oder vieleckförmigen Grundplatte (1), deren Rand und Zentrum mit Leuchtdioden (2, 5) unterschiedlicher Farbe bestückt sind. Ein gemeinsamer Gießharzkörper (8) umhüllt die Leuchtdioden und bildet die Grundplatte sowie einen Gewindeansatz (9) zum Befestigen der Einrichtung (Figur 2).

Fig. 2

EP 0 108 368 A1

Croydon Printing Company Ltd.

HONEYWELL-ELAC-NAUTIK GMBH
Westring 425 - 429
2300 Kiel 1

28. Oktober 1983
74100482 EP
HR/de

Optische Warn- oder Anzeigeeinrichtung mit
    Leuchtdioden.

Bekannt sind Warnblinkleuchten mit einer domartigen Schutzkappe aus Glas oder durchscheinendem Kunststoff, in deren
Zentrum eine Glühlampe angeordnet ist. Die domartige Schutzkappe ermöglicht einen Lichtaustritt sowohl in Umfangsrichtung, als auch senkrecht zur Grundfläche der Schutzkappe.
Weiterhin ist die Verwendung von Leuchtdioden unterschiedlicher Farbe zur Kennzeichnung der Funktionsbereitschaft
oder bestimmter Betriebszustände von Geräten und Fahrzeugen
bekannt, beispielsweise bei Regelgeräten die Verwendung
einer grünen Leuchtdiode zur Betriebsbereitschaftsanzeige
und einer roten zur Alarmmeldung. Die Leuchtdioden sind für
diesen Zweck üblicherweise hinter oder an einer Gehäusewand
oder einem Armaturenbrett derart angeordnet, daß sie bei
Draufsicht auf diese Gerätewand oder das Armaturenbrett gut
sichtbar sind.

Aufgabe der Erfindung ist es, eine Warn- oder Anzeigevorrichtung
mit Leuchtdioden zu schaffen, welche nicht nur in Draufsicht, sondern von mehreren Seiten, also vorzugsweise in
einem Raumwinkelbereich von 180° deutlich erkennbar ist.
Diese Aufgabe wird gelöst durch die im Anspruch 1 gekennzeichnete Erfindung. Sie zeichnet sich durch einen platzsparenden und preisgünstig herstellbaren Aufbau aus herkömmlichen Bauelementen aus und ist in vielseitiger Weise
bei Geräten, Maschinen, Schalttafeln, Fahrzeugen und Anzeigevorrichtungen einsetzbar. Vorteilhafte Ausgestaltungen er-

- 2 -

geben sich aus den Unteransprüchen.

Zur Erläuterung ist in der Zeichnung ein Ausführungsbeispiel dargestellt. Es zeigt in

Fig. 1  eine seitliche Ansicht der Warneinrichtung,
        in

Fig. 2  einen zentralen Schnitt hierdurch und in

Fig. 3  eine Draufsicht auf ihre Stirnfläche.

Auf einer eine Kreisfläche oder Vieleckfläche bildenden
Kunstharzgrundplatte 1 sind über deren Umfang verteilt acht
rote Leuchtdioden 2 angebracht, deren Elektrodenpaare 3
elektrisch miteinander verbunden und an Stromzuführungsleitungen 4 angeschlossen sind. Im Zentrum der Platte 1
ist auf dieser eine grüne Leuchtdiode 5 angeordnet, deren
Elektroden 6 an ein weiteres Zuleitungspaar 7 geführt sind.
Alle Leuchtdioden 2 und 5 sind mittels eines einheitlichen,
zugleich die Grundplatte 1 bildenden Gießharzkörpers 8 zusammengehalten, der zugleich einen Gewindeansatz 9 umfaßt,
mit dessen Hilfe die Warneinrichtung, beispielsweise in
eine Gerätewand eingeschraubt oder anderweitig befestigt
werden kann. Ein O-Ring 10 dient dabei der Abdichtung. Der
einheitliche Gießharzkörper 8 ist im Übergangsbereich
zwischen seiner Umfangsfläche 11 und seiner Stirnfläche 12
unter 45° abgeschrägt und weist im Bereich jeder der an
seinem Rand vorgesehenen Leuchtdioden 2 sowohl Lichtaustrittsflächen 13 in Umfangsrichtung, als auch Lichtaustrittsflächen 14 im Bereich der Abschrägung sowie Lichtaustrittsflächen 15 auf der Stirnfläche auf. Damit ist eine
Abstrahlung des Lichts der Leuchtdioden 2 in einem Raumwinkelbereich von 180° gewährleistet. Die zentrale Leuchtdiode 5 weist nur eine ihr auf der Stirnfläche der Schutzkappe 8 vorgelagerte Lichtaustrittsfläche 16 auf. Die grüne
Leuchtdiode 5 kann beispielsweise als Betriebsbereitschaftsanzeige dienen, während die roten Leuchtdioden 2 als Warn-

- 3 -

einrichtung im Blink- oder Dauerlichtbetrieb eingesetzt werden. Um die von den beiden Gruppen von Leuchtdioden 2 und 5 ausgehende Strahlung farblich besser trennen zu können, kann man die der zentralen Leuchtdiode 5 zugewandten Begrenzungsflächen der am Rand vorgesehenen Leuchtdioden 2 mit einer spiegelnden Schicht 17 versehen. Da die Schutzkappe 8 mit der Grundplatte 1 und dem Gewindeansatz 9 ein einstückiges Bauteil bildet, in welches die Leuchtdioden 2 und 5 sowie deren Anschlußdrähte 18 eingegossen sind, ergibt sich ein besonders robuster, erschütterungsunempfindlicher Aufbau der Warneinrichtung, die sich zudem leicht montieren und auswechseln läßt. Der Kunstharzkörper 8 besteht aus einem durchsichtigen oder durchscheinenden Kunstharz. Die Lichtaustrittsflächen 13, 14, 15, 16 sind durch Schnittflächen gebildet, welche Teile 19 der ursprünglichen Hüllkörper der Leuchtdioden 2 und 5 abschneiden. Zur Anzeige unterschiedlicher Betriebszustände oder Funktionen des mit der Anzeigeeinrichtung ausgestatteten Gerätes können auch am Rand Leuchtdioden unterschiedlicher Farbe verwendet und die Leuchtdioden zu Gruppen unterschiedlicher Farbe, Größe oder räumlicher Anordnung elektrisch zusammengeschaltet werden. Zusätzliche Spiegelflächen können zwischen den verschiedenen Leuchtdiodengruppen vorgesehen sein. Anstelle einer einzigen Leuchtdiode 5 im Zentrum der Grundplatte 1 können dort auch mehrere gegebenenfalls unterschiedlich gefärbte Leuchtdioden, z.B. in einer Dreieckanordnung oder in einer weiteren konzentrischen Ringanordnung vorgesehen sein.

Patentansprüche

1. Optische Warn- oder Anzeigeeinrichtung mit Leuchtdioden, d a d u r c h   g e k e n n z e i c h n e t , daß die Leuchtdioden (2) am Rande einer Kreis- oder Vieleckplatte (1) angeordnet und von einer Schutzkappe (8) umgeben sind, welche Lichtaustrittsflächen (13, 15) sowohl in Umfangsrichtung, als auch in Richtung ihrer Stirnfläche (12) aufweist.

2. Einrichtung nach Anspruch 1, d a d u r c h   g e - k e n n z e i c h n e t , daß die Schutzkappe (8) im Übergangsbereich zwischen Umfangsfläche (11) und Stirnfläche (12) unter vorzugsweise 45° abgeschrägt und auch im Bereich dieser Abschrägung mit Lichtaustrittsflächen (14) versehen ist.

3. Einrichtung nach Anspruch 2, d a d u r c h   g e - k e n n z e i c h n e t , daß die im Bereich jeder Leuchtdiode (2) auf der Umfangsfläche (11), der Abschrägung (14) und der Stirnfläche (12) vorgesehenen Lichtaustrittsflächen jeweils eine einzige zusammenhängende Lichtaustrittsfläche (13, 14, 15) bilden.

4. Einrichtung nach einem der Ansprüche 1 - 3, d a - d u r c h   g e k e n n z e i c h n e t , daß im Zentrum der Kreis- oder Vieleckplatte eine weitere Leuchtdiode (5) angeordnet und dieser vorgelagert auf der Stirnfläche (12) der Schutzkappe (8) eine weitere Lichtaustrittsfläche (16) vorgesehen ist.

5. Einrichtung nach einem der Ansprüche 1 - 4, d a d u r c h   g e k e n n z e i c h n e t , daß die Schutzkappe (8) aus einem die Leuchtdioden (2, 5) umschließenden Gießharzkörper besteht.

6. Einrichtung nach Anspruch 5, d a d u r c h g e - k e n n z e i c h n e t , daß der Gießharzkörper (8) aus einem durchscheinendem Kunststoff besteht.

7. Einrichtung nach Anspruch 5 oder 6, d a d u r c h g e k e n n z e i c h n e t , daß der Gießharzkörper (8) die Form eines Zylinders mit aufgesetztem Kegelstumpf hat, in den die Leuchtdioden (2, 5) eingebettet sind.

8. Einrichtung nach einem der Ansprüche 1 - 7, d a d u r c h g e k e n n z e i c h n e t , daß die Vieleck- oder Kreisplatte (1) auf der der Stirnfläche (12) abgewandten Seite einen die elektrischen Anschlußdrähte (18) umschließenden Gewindeansatz (9) trägt.

9. Einrichtung nach Anspruch 8, d a d u r c h g e k e n n - z e i c h n e t , daß die Kreis- oder Vieleckplatte (1), die Schutzkappe (8) und der Gewindeansatz (9) als einstückiger Gießharzkörper ausgebildet sind.

10. Einrichtung nach einem der Ansprüche 1 - 9, d a - d u r c h g e k e n n z e i c h n e t , daß die Licht- austrittsflächen (13-16) durch Schnittflächen der Leuchtdioden-Hüllkörper gebildet sind.

11. Einrichtung nach einem der Ansprüche 1 - 10, d a - d u r c h g e k e n n z e i c h n e t , daß die Leucht- dioden (2, 5) zu Gruppen unterschiedlicher Farbe, Größe und/oder räumlicher Anordnung elektrisch zusammengeschaltet sind.

12. Einrichtung nach Anspruch 11, d a d u r c h g e - k e n n z e i c h n e t , daß Begrenzungsflächen zwischen den Leuchtdiodengruppen (z.B. 2 und 5) mit einer spiegelnden Schicht (17) versehen sind.

0108368

Fig. 1

Fig. 2

Fig. 3

## EUROPÄISCHER RECHERCHENBERICHT

Europäisches
Patentamt

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| X | FR-A-2 339 922  (BOURBOULON) <br><br> * Figuren 1,2 * | 1,4,6, 11 | F 21 Q    3/00 <br> H 01 L   33/00 |
| X | DE-A-2 315 709  (LICENTIA PATENT) <br> * Figuren 1-2 * | 1,4,6, 8,11 | |
| A | US-A-3 581 162  (WHEATLEY) <br> * Figur 1 * | 1,4,8 | |
| A | DE-A-2 814 877  (ME MEERESTECHNIK-ELEKTRONIK) <br> * Seite 9, Zeilen 3-7 * | 1,5,6 | |
| A | US-A-4 148 096  (HAAS) <br> * Figur 3 * | 2,3,4 | RECHERCHIERTE SACHGEBIETE (Int. Cl. 3) |
| A | FR-A-1 591 709  (LENTE) <br> * Figuren 5,7 * | 2,5,6 | F 21 Q <br> H 01 L <br> G 09 F <br> F 21 V |
| A | DE-A-2 531 968  (STAHL) <br> * Figuren 3,4 * | 4,6,12 | F 21 K |

Der vorliegende Recherchenbericht wurde für alle Patentansprüche erstellt.

| Recherchenort <br> DEN HAAG | Abschlußdatum der Recherche <br> 08-02-1984 | Prüfer <br> FOUCRAY R.B.F. |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

.............

& : Mitglied der gleichen Patentfamilie, übereinstimmendes Dokument

EPA Form 1503. 03.82